Europäisches Patentamt

European Patent Office

Office européen des brevets

(11) Numéro de publication: **0 327 964 B1**

# (12) FASCICULE DE BREVET EUROPEEN

(45) Date de publication de fascicule du brevet: **09.12.92**  (51) Int. Cl.⁵: **G02B 26/02**, H04Q 3/52

(21) Numéro de dépôt: **89101797.2**

(22) Date de dépôt: **02.02.89**

(54) **Interrupteur à fibre optique.**

(30) Priorité: **08.02.88 FR 8801452**

(43) Date de publication de la demande:
**16.08.89 Bulletin 89/33**

(45) Mention de la délivrance du brevet:
**09.12.92 Bulletin 92/50**

(84) Etats contractants désignés:
**AT BE CH DE ES FR GB IT LI NL SE**

(56) Documents cités:
**GB-A- 1 460 211**

**IBM DISCLOSURE BULLETIN, vol. 16, no. 8, janvier 1974, page 2452, New York, US; K. KASER et al.: "Push buttom switches for optical fibres"**

(73) Titulaire: **Société Anonyme dite: CEGELEC
13, rue Antonin Raynaud
F-92309 Levallois-Perret(FR)**

(72) Inventeur: **Tardy, André
19 avenue d'Arpajon
F-91520 Egly(FR)**
Inventeur: **Jurczyszyn, Michel
68 rue Gabriel-Péri
F-94200 Ivry sur Seine(FR)**

(74) Mandataire: **Weinmiller, Jürgen et al
Lennéstrasse 9 Postfach 24
W-8133 Feldafing(DE)**

## Description

La présente invention concerne un interrupteur à fibre optique, pouvant intervenir par exemple comme composant terminal d'un réseau à fibre optique spécialisé dans la collection d'informations de type binaire.

Le problème technique qui se pose est la fiabilité d'un tel interrupteur qui doit pouvoir subir sans défaillance plusieurs millions de manoeuvres.

On connaît des interrupteurs optiques fonctionnant en rétroréflexion (voir par exemple "IBM Technical Disclosure Bulletin", Vol. 16, No. 8, Jan. 1974, page 2452: K. Kaser et al., "Push-button switches for optical fibres"), autrement dit des interrupteurs contenant un tronçon de fibre dont une extrémité est réfléchissante. Ainsi ce même tronçon de fibre transmet à la fois le signal lumineux incident et le signal lumineux modulé par le capteur ayant agi sur l'interrupteur. Généralement ledit tronçon de fibre est coupé et on réalise la modulation du signal par la mise en oeuvre d'un atténuateur optique que l'on intercale ou pas entre les deux portions du tronçon de fibre. Lorsque l'interrupteur est sollicité, l'atténuateur entraîne par exemple un affaiblissement de 50 % du signal. On a un interrupteur "TOUT" ou "PEU".

Un tel dispositif présente des inconvénients du point de vue de la fiabilité. Il nécessite la mise en oeuvre de moyens d'escamotage complexes. Il implique la coupure du tronçon de fibre et donc la réalisation d'un alignement optique supplémentaire avec les risques de perte de lumière qui en résultent. On est en présence de plusieurs dioptres (faces d'entrée des deux fibres et faces de l'atténuateur) qui, à la longue, peuvent être altérés par la poussière environnante et modifier les performances de l'interrupteur.

La présente invention a pour but d'éviter toutes ces pertes d'insertion et de réaliser un interrupteur à fibre optique, fiable, dont la structure puisse être bien protégée du milieu extérieur.

La présente invention a pour objet un interrupteur à fibre optique fonctionnant en rétroréflexion, comportant un tronçon de fibre optique dont une extrémité est destinée à être raccordée à une borne optique et dont l'autre extrémité est réfléchissante, ledit interrupteur comportant en outre un dispositif mécanique commandable pour moduler l'énergie lumineuse transmise par ladite fibre; il est caractérisé par le fait que ladite extrémité réfléchissante est libre, et qu'entre cette dernière et ladite borne optique ladite fibre est disposée entre deux mâchoires à profils complémentaires dont l'une est rendue mobile par rapport à l'autre par un bouton poussoir, de manière à imprimer localement à ladite fibre un déplacement transversal de l'ordre de quelques dizaines de micromètres, réalisant ainsi un interrupteur à transmission "TOUT" ou "PEU". Ladite fibre est en verre de silice et ne comporte pas de gaine plastique.

Selon un mode de réalisation préférentiel, lesdites mâchoires appartiennent aux deux branches d'une pièce métallique en forme de U, susceptible de présenter une déformation élastique sous l'effet dudit bouton poussoir; lesdites mâchoires présentent un profil sensiblement sinusoïdal. Sur le profil de chaque mâchoire est fixée une lame plane métallique très fine destinée à éviter l'abrasion de ladite fibre. Une butée est prévue entre lesdites mâchoires pour limiter ledit déplacement transversal.

De préférence, ladite fibre est fixée ponctuellement sur un pion situé entre lesdites mâchoires et ladite borne optique.

Selon un mode de réalisation particulier l'interrupteur selon l'invention comporte en outre un levier de renvoi de direction de manoeuvre susceptible d'agir sur ledit bouton poussoir.

D'autres caractéristiques et avantages de la présente invention apparaîtront au cours de la description suivante d'un mode de réalisation donné à titre illustratif mais nullement limitatif. Dans le dessin annexé :

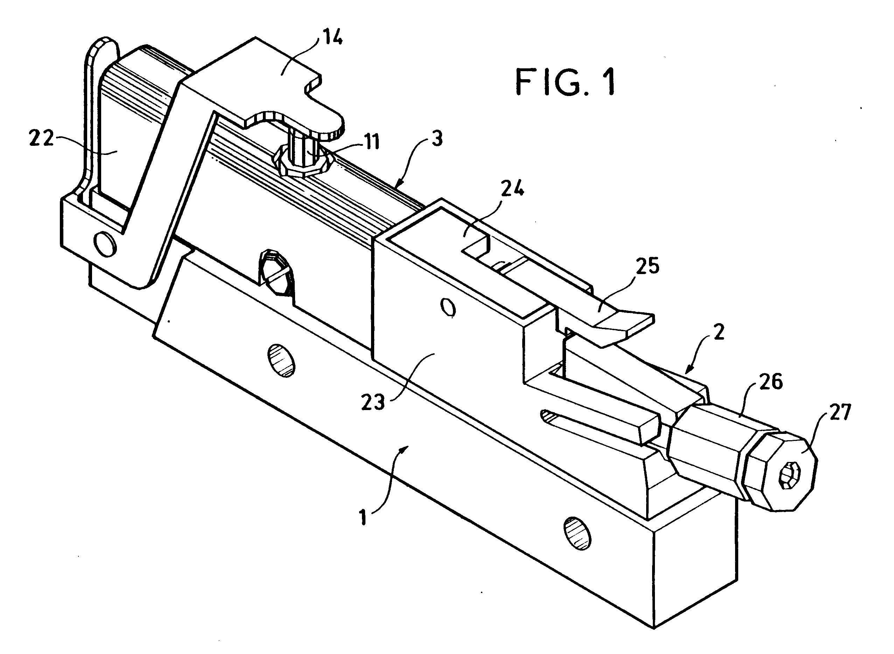

- La figure 1 est une vue en perspective d'un interrupteur selon l'invention monté avec sa borne optique.
- La figure 2 est une vue en perspective éclatée de l'interrupteur de la figure 1.
- La figure 3 est une vue en perspective agrandie des mâchoires de la figure 2 destinées à enserrer la fibre optique.
- La figure 4 est une vue en perspective analogue à celle de la figure 1, sans le capot extérieur et sans la borne optique de raccordement.

L'interrupteur selon l'invention comporte une embase 1 destinée à supporter la borne optique de raccordement 2 et le dispositif mécanique commandable 3 destiné à moduler l'énergie lumineuse transmise par une fibre 20.

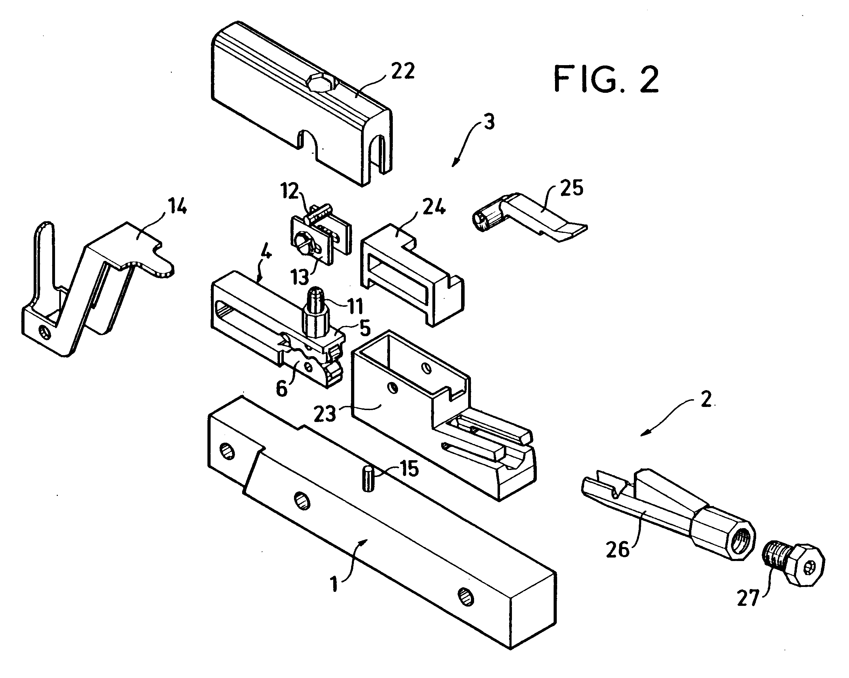

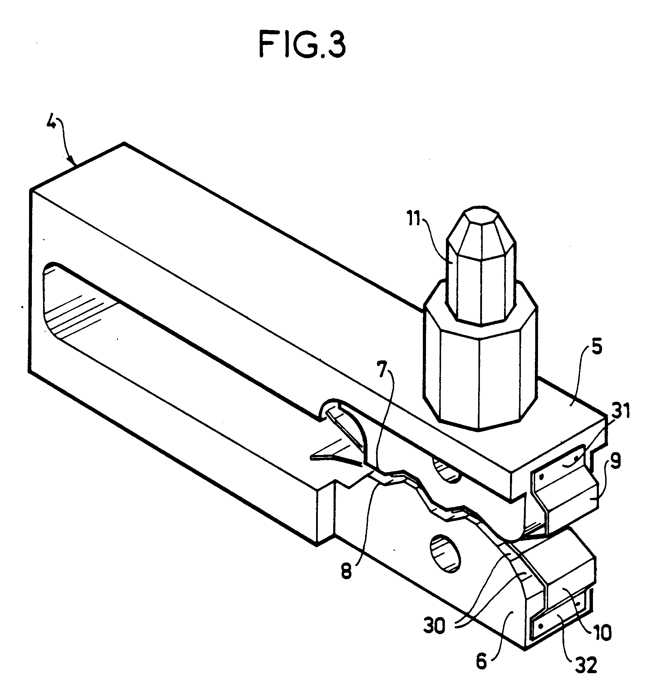

Le dispositif 3 visible dans les figures 2, 3 et 4 comporte une pièce 4 en U en acier dont on a référencé les deux branches 5 et 6, et qui présente une certaine élasticité. Chaque face interne des branches 5 et 6 est usinée et présente un profil 7, 8 sensiblement sinusoïdal (voir figure 3); ce profil est formé d'une succession de petites facettes 30 formant un réseau.

Chaque profil est recouvert d'une lame métallique très mince 9,10 qui épouse sa forme lors du déplacement des réseaux; une extrémité de chaque lame est fixée par exemple par soudage en 31, 32 à la branche correspondante de la pièce 4 mais l'autre extrémité est libre de manière à pouvoir bouger vis-à-vis de la pièce 4 en cas de sollicitation de l'interrupteur. Cette dernière est réalisée par la mise en oeuvre d'un bouton poussoir à ressort 11.

Une goupille 12 solidaire de la branche mobile 5 vient en appui sur une butée réglable 13 solidaire de la branche fixe 6. La butée permet de définir le déplacement relatif des deux branches 5 et 6 qui est de l'ordre de quelques dizaines de micromètres pour le passage à la transmission "TOUT" à la transmission "PEU". Elle permet également de définir le déplacement relatif des deux branches 5 et 6 pour le passage de la transmission "0".

Le levier 14 permet le renvoi de la direction de manoeuvre du bouton poussoir 11.

On a référencé 22 un capot de protection; 23, 24 et 25 sont des pièces destinées à la mise en place sur le capot 1, en regard du tronçon de fibre 20, de la borne optique 2 comportant les pièces 26 et 27.

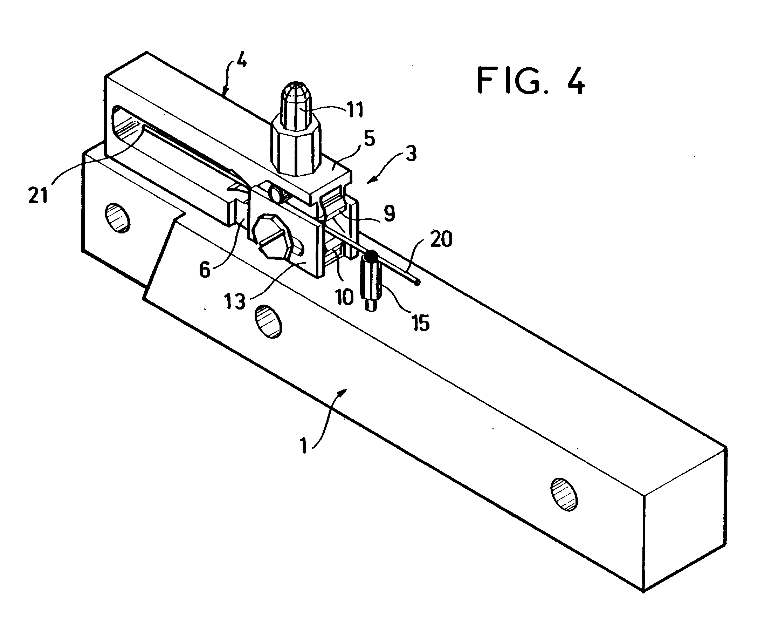

On voit dans les figures 2 et 4 un pion 15 pour la fixation du tronçon de fibre 20 dont l'extrémité 21 réfléchissante est libre.

La fibre 20 est une fibre multimode à gradient d'indice, dont le diamètre du coeur est 100 micromètres, dont le diamètre de la gaine est 140 micromètres, et dont l'ouverture numérique est 0,28. Cette fibre est totalement en verre et ne présente pas de gainage en matière plastique de manière à éviter tout comportement non élastique en cas de sollicitation mécanique. L'extrémité réfléchissante 21 de la fibre 20 peut être obtenue par un dépôt métallique, un dépôt d'un matériau diélectrique, ou par l'intermédiaire d'un élément réfléchissant ajouté et collé.

Lorsque l'interrupteur est sollicité par l'intermédiaire du bouton poussoir 11 ou du levier 14, la branche 5 se déplace de la quantité définie par la cale 13. Les lames 9 et 10 qui emprisonnent la fibre 20 peuvent glisser le long des profils puisqu'elles ont une extrémité libre. Par contre la fibre ne bouge pas par rapport aux lames et ne risque pas d'être endommagée. Pour la fibre dont les caractéristiques ont été données ci-dessus, un déplacement transversal de 15 micromètres est suffisant pour induire une variation de l'ordre de 25% dans la transmission de l'énergie lumineuse. Comme l'interrupteur fonctionne en rétroréflexion, ceci conduit à une variation de transmission voisine de 50%. Grâce à l'élasticité de la pièce 4, la branche 5 du U revient à sa position initiale après la suppression de la force de commande.

Bien entendu l'invention n'est pas limitée au mode de réalisation qui vient d'être décrit. La mise en oeuvre de lames minces intermédiaires entre les branches du U et la fibre optique permet d'accroître notablement la fiabilité du dispositif car elles évitent toute détérioration superficielle de cette fibre. Toutefois il peut être envisagé de revêtir la fibre optique d'une gaine métallique de plusieurs micromètres d'épaisseur en un métal plus dur que celui des profils.

Un interrupteur selon l'invention est capable de supporter au moins quatre millions de sollicitations. Il présente en outre les avantages suivants :

. A l'état non sollicité, l'interrupteur ne présente pas de perte d'insertion contrairement aux interrupteurs de l'art antérieur qui font intervenir un écran total ou partiel inséré entre deux fibres,

. L'énergie optique utile étant toujours confinée à l'intérieur de la fibre, le fonctionnement du composant n'exige pas de propreté excessive de l'environnement de cette fibre.

. La modulation optique étant analogique, il est aisé de réaliser la fonction "TOUT" ou "PEU" par simple définition du déplacement relatif des deux branches 5 et 6 de la pièce 4. La fonction "TOUT" ou "PEU" est utile pour pouvoir mettre en évidence une valeur de transmission nulle correspondant à une coupure de la fibre optique.

L'interrupteur selon l'invention peut bien entendu être utilisé dans des environnements très perturbés du point de vue chimique ou du point de vue électromagnétique.

## Revendications

1. Interrupteur à fibre optique fonctionnant en rétroréflexion, comportant un tronçon de fibre optique (20) dont une extrémité est destinée à être raccordée à une borne optique et dont la face frontale de l'autre extrémité (21) est réfléchissante, ledit interrupteur comportant en outre un dispositif mécanique commandable (3) pour moduler l'énergie lumineuse transmise par ladite fibre, caractérisé par le fait que ledit dispositif mécanique comporte deux mâchoires (5, 6) à profils complémentaires (7, 8) dont l'une est rendue mobile par rapport à l'autre par un bouton poussoir (11), de manière à imprimer à une zone intermédiaire dudit tronçon de fibre optique disposée entre lesdites deux mâchoires un déplacement transversal de l'ordre de quelques dizaines de micromètres, la portion dudit tronçon de fibre qui comporte ladite face frontale réfléchissante et qui s'étend au-delà de ladite zone intermédiaire étant libre de manière à ne pas subir de contraintes mécaniques lors dudit déplacement transversal, l'ensemble réalisant ainsi un interrupteur à transmission "TOUT" ou "PEU".

2. Interrupteur à fibre optique selon la revendication 1, caractérisé par le fait que lesdites mâchoires appartiennent aux deux branches (5 et 6) d'une pièce métallique (4) en forme de U, susceptible de présenter une déformation élastique sous l'effet dudit bouton poussoir (11).

3. Interrupteur à fibre optique selon l'une des revendications 1 et 2, caractérisé par le fait que lesdites mâchoires présentent un profil sensiblement sinusoïdal.

4. Interrupteur à fibre optique selon l'une des revendications précédentes, caractérisé par le fait que sur le profil de chaque mâchoire est fixée une lame métallique très fine (9, 10) destinée à éviter l'abrasion de ladite fibre.

5. Interrupteur à fibre optique selon l'une des revendications précédentes, caractérisé par le fait qu'une butée (13) est prévue entre lesdites mâchoires pour limiter leur déplacement relatif.

6. Interrupteur à fibre optique selon l'une des revendications précédentes, caractérisé par le fait qu'entre lesdites mâchoires et ladite borne optique, ladite fibre est fixée ponctuellement sur un pion (15).

7. Interrupteur à fibre optique selon l'une des revendications précédentes, caractérisé par le fait qu'il comporte un levier (14) de renvoi de direction de manoeuvre susceptible d'agir sur ledit bouton poussoir.

8. Interrupteur à fibre optique selon l'une des revendications précédentes, caractérisé par le fait que ladite fibre est une fibre multimode à gradient d'indice, en verre de silice sans gaine plastique, de diamètre de coeur égal à 100 micromètres, de diamètre de gaine égal à 140 micromètres, et d'ouverture numérique 0,28.

## Claims

1. Optical fibre switch operating by rectroreflection comprising a section of optical fibre (20) with one end adapted to be connected to an optical terminal and the front surface of the other end (21) of which is reflective, said switch further comprising a mechanical device (3) adapted to be actuated to modulate the luminous energy transmitted by said fibre, characterised in that said mechanical device comprises two jaws (5, 6) having complementary profiles (7, 8) one of which is movable relative to the other by a pushbutton (11) so as to apply to an intermediate area of said optical fibre section disposed between said two jaws transverse displacement in the order of a few tens of micrometres, the portion of said section of fibre which comprises said reflective front surface and which extends beyond said intermediate area being free so as not to be exposed to mechanical stresses during said transverse displacement, so providing a transmit "ALL" or transmit "LITTLE" switch.

2. Optical fibre switch according to claim 1 characterised in that said jaws are parts of two branches (5 and 6) of a U-shape metal part (4) adapted to be deformed elastically by said pushbutton (11).

3. Optical fibre switch according to claim 1 or claim 2 characterised in that said jaws have a substantially sinusoidal profile.

4. Optical fibre switch according to any one of the preceding claims characterised in that to the profile of each jaw is fixed a very thin metal blade (9, 10) adapted to prevent abrasion of said fibre.

5. Optical fibre switch according to any one of the preceding claims characterised in that an abutment (13) is provided between said jaws to limit their relative displacement.

6. Optical fibre switch according to any one of the preceding claims characterised in that said fibre is fixed at one point to a pin (15) between said jaws and said optical terminal.

7. Optical fibre switch according to any one of the preceding claims characterised in that it comprises an actuation direction changing lever (14) adapted to operate on said pushbutton.

8. Optical fibre switch according to anyone of the preceding claims characterised in that said fibre is a graded index multimode fibre made from silica glass with no plastics material jacket and having a core diameter equal to 100 micrometres, a sheath diameter equal to 140 micrometres and a numerical aperture equal to 0.28.

## Patentansprüche

1. Mit Retroreflektion arbeitender Lichtfaserschalter, der einen Lichtfaserabschnitt (20) aufweist, von dem ein Ende mit einem optischen Anschluß verbunden werden soll und die Stirnfläche des anderen Endes (21) reflektierend ist, wobei der Schalter weiter eine steuerbare mechanische Vorrichtung (3) aufweist, um die von der Faser übertragene Lichtenergie zu modulieren, dadurch gekennzeichnet, daß die mechanische Vorrichtung zwei Backen (5, 6) mit komplementären Profilen (7, 8) aufweist, von denen eine in Bezug auf die andere durch eine Taste (11) bewegbar ist, um einem Zwischenbereich des Lichtfaserabschnitts, der zwischen den beiden Backen angeordnet ist, eine transversale Verschiebung von einigen zehn Mikrometern zu verleihen, wobei der Bereich des Faserabschnitts, der die reflektierende Stirnfläche aufweist und der sich über den Zwischenbereich hinaus erstreckt, frei ist, derart, daß er während der transversalen Verschiebung keinen mechanischen Beanspruchungen unterworfen ist, so daß sich ein Schalter mit Übertragung "ALLES" oder "WENIG" ergibt.

2. Lichtfaserschalter nach Anspruch 1, dadurch gekennzeichnet, daß die Backen zu den beiden Armen (5 und 6) eines U-förmigen Metallteils (4) gehören, das unter der Einwirkung der Taste (11) eine elastische Verformung zeigen kann.

3. Lichtfaserschalter nach einem der Ansprüche 1 und 2, dadurch gekennzeichnet, daß die Bakken ein im wesentlichen sinusförmiges Profil haben.

4. Lichtfaserschalter nach einem der vorhergehenden Ansprüche, dadurch gekennzeichnet, daß auf dem Profil jeder Backe eine sehr dünne flache Metallamelle (9, 10) befestigt ist, die den Abrieb der Faser verhindern soll.

5. Lichtfaserschalter nach einem der vorhergehenden Ansprüche, dadurch gekennzeichnet, daß ein Anschlag (13) zwischen den Backen vorgesehen ist, um ihre relative Verschiebung zu begrenzen.

6. Lichtfaserschalter nach einem der vorhergehenden Ansprüche, dadurch gekennzeichnet, daß die Faser zwischen den Backen und dem optischen Anschluß punktförmig auf einem Stift (15) befestigt ist.

7. Lichtfaserschalter nach einem der vorhergehenden Ansprüche, dadurch gekennzeichnet, daß er einen Umlenkhebel (14) für die Betätigung der Taste aufweist.

8. Lichtfaserschalter nach einem der vorhergehenden Ansprüche, dadurch gekennzeichnet, daß die Faser eine Multimodefaser aus Quarzglas mit Indexgradient ohne Kunststoffhülle ist, mit einem Kerndurchmesser gleich 100 Mikrometer, mit einem Hüllendurchmesser gleich 140 Mikrometer und einer numerischen Öff-

nung von 0,28.

FIG. 1

FIG. 2

EP 0 327 964 B1

# FIG.3

FIG. 4